## Europäisches Patentamt

## European Patent Office

## Office européen des brevets

(11) Veröffentlichungsnummer: **0 104 470**
**B1**

(12) **EUROPÄISCHE PATENTSCHRIFT**

(45) Veröffentlichungstag der Patentschrift:
25.01.89

(51) Int. Cl.⁴: **H 03 M 3/04**

(21) Anmeldenummer: **83108504.8**

(22) Anmeldetag: **29.08.83**

(54) **Schneller DPCM-Kodierer.**

(30) Priorität: **01.09.82 DE 3232516**

(43) Veröffentlichungstag der Anmeldung:
**04.04.84 Patentblatt 84/14**

(45) Bekanntmachung des Hinweises auf die Patenterteilung:
**25.01.89 Patentblatt 89/4**

(84) Benannte Vertragsstaaten:
**AT BE CH DE FR GB IT LI NL SE**

(56) Entgegenhaltungen:
**WO-A-80/00207**

(73) Patentinhaber: **Siemens Aktiengesellschaft Berlin und München, Wittelsbacherplatz 2, D-8000 München 2 (DE)**

(72) Erfinder: **Grallert, Hans- Joachim, Dr.- Ing., Tannenfleckstrasse 30, D-8038 Gröbenzell (DE)**

**Beschreibung**

Die Erfindung betrifft einen schnellen DPCM-Kodierer mit einem Quantisierer und mit mehreren Rechenschleifen zur Ermittlung eines DPCM-Signalwertes, bei dem von einem Abtastwert mehrere Zwischenwerte, von denen mindestens einer in einer Recheneinheit ermittelt wird, in Subtrahierern subtrahiert werden, die dem Quantisierer in Reihe vorgeschaltet sind.

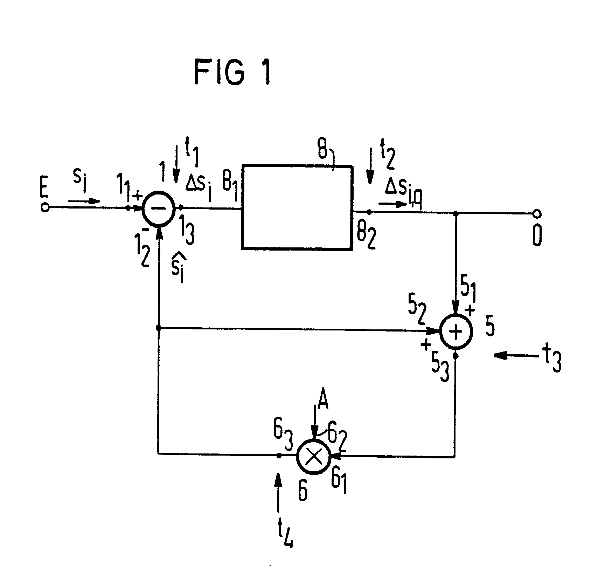

Bei der digitalen Übertragung oder Speicherung von Signalen wird häufig das Differenz-Puls-Kode-Modulations-Verfahren angewendet. Dabei wird für den aktuellen Abtastwert $s_i$ aus vorhergehenden Abtastwerten $s_{i-k}$ ein Schätzwert $\hat{s}_i$ berechnet. Die Differenz - als DPCM-Signalwert bezeichnet - $\Delta s_i = s_i - \hat{s}_i$ wird quantisiert und anschließend übertragen. Ziel des Verfahrens ist es, zur Darstellung von $\Delta s_i$ eine kleinere Wortlänge zu verwenden, als zur Darstellung der PCM-Signalwerte $s_i$ erforderlich ist. Die notwendige Übertragungsrate bzw. der Speicherplatzbedarf werden dadurch geringer. In Fig. 1 ist eine einfache DPCM-Schleife dargestellt, deren Funktion noch genauer erläutert wird. Die Berechnung des Schätzwertes $\hat{s}_i$ erfolgt in vier Schritten. Diese vier Rechenschritte müssen innerhalb einer Zeit durchgeführt werden, die dem zeitlichen Abstand zweier aufeinanderfolgender PCM-Signalwerte $s_i$, $s_{i+1}$ entspricht. Bei hohen Datenraten steht für diese vier Rechenoperationen nur wenig Zeit zur Verfügung, so daß eine Realisation auch bei Verwendung modernster Schaltkreistechniken schwierig oder unmöglich ist.

In der internationalen Anmeldung WO-A1-80/00 207 ist ein DPCM-Kodierer beschrieben, der mehrere Rechenschleifen aufweist. Dieser DPCM-Kodierer benutzt zur Errechnung eines Prädiktionswertes Prädiktionskoeffizienten, die sowohl positive als auch negative Werte von 1 einschließen. Um Signale mit hohen Datenraten verarbeiten zu können, erfolgt die Berechnung in mehreren parallel arbeitenden Rechenschleifen. Der am Ausgang einer als Quantisierer wirkenden Kompressor/Expander-Reihenschaltung abgegebene quantisierte DPCM-Signalwert wird direkt auf einen vor dem Quantisierer liegenden Subtrahierer rückgekoppelt. In bekannter Weise wird in einem ersten Prädiktor ein rekonstruierter Signalwert $S_0$ ermittelt und dieser wird in mindestens einem weiteren vorgeschalteten Subtrahierer vom jeweiligen Signalwert subtrahiert. In der nächsten Verarbeitungstaktphase wird von dieser Differenz der quantisierte DPCM-Signalwert subtrahiert. Zeitkritisch ist in der Kodierschleife nur die Verarbeitung des letzten quantisierten DPCM-Signalwertes, dessen Prädiktionsfaktor hier 1 ist.

Die Ermittlung von Schätzwerten mit Hilfe von positiven und negativen Koeffizienten wird jedoch für die Bildkodierung heute nicht mehr verwendet. Dies bedeutet jedoch, daß alle Koeffizienten kleiner als 1 sind und daher in den Rechenschleifen zeitintensive Multiplikationen durchzuführen sind. Der beschriebene Kodierer ist daher für Prädiktionskoeffizienten, die alle kleiner als 1 sind, nicht geeignet.

Aufgabe der Erfindung ist es, einen DPCM-Kodierer mit kurzer Verarbeitungszeit für beliebige Prädiktionsfaktoren anzugeben.

Ausgehend vom eingangs beschriebenen Stand der Technik, wird diese Aufgabe durch die im Patentanspruch 1 angegebenen Merkmale gelöst.

Bei diesem DPCM-Kodierer erfolgt die Berechnung der DPCM-Signalwerte durch parallele Berechnung von Zwischenwerten, die mit den am Eingang der Schaltungsanordnung anliegenden PCM-Signalwerten in drei aufeinanderfolgenden Rechenoperationen verknüpft werden, bis das noch zu quantisierende DPCM-Signal vorliegt. Durch den speziellen Quantisierer wird keinerlei Rechenzeit für die im allgemeinen notwendigen Multiplikationen benötigt. Nach jeweils zwei aufeinanderfolgenden Rechenoperationen wird ein neuer quantisierter DPCM-Signalwert ermittelt. Diese Schaltung kann so realisiert werden, daß jedes zweite hintereinanderliegende Rechenelement mit demselben Takt arbeitet. Für jede Rechenoperation steht dann die Hälfte der Impulsperiode der zu verarbeitenden PCM-Signalwerte zur Verfügung.

Es ist zweckmäßig, daß ein dritter Ausgang des Quantisierers vorgesehen ist, an dem die quantisierten DPCM-Signalwerte abgegeben werden.

Bei dieser Lösung kann das quantisierte DPCM-Signal direkt am Ausgang des Quantisierers abgenommen werden.

Zur Verringerung das Aufwandes kann es zweckmäßig sein, daß ein zusätzlicher Multiplizierer vorgesehen ist, der an den ersten oder zweiten Ausgang des Quantisierers angeschaltet ist und durch Multiplikation mit $\frac{1}{A}$ oder $\frac{1}{A}$ jeweils den quantisierten DPCM-Signalwert $\Delta s_{i,q}$ errechnet.

Bei dieser Lösung wird das quantisierte DPCM-Signal aus einem der beiden von Quantisierer abgegeben Signale berechnet.

Es ist vorteilhaft, daß die Recheneinheit einen Addierer enthält, dessen erster Eingang an den zweiten Ausgang des Quantisierers angeschlossen ist, daß der Ausgang des Addierers mit dem ersten Eingang eines ersten Multiplizierers verbunden ist, dessen zweitem Eingang der Prädiktionsfaktor zugeführt ist und dessen Ausgang an den zweiten Eingang des Addierers geführt ist und außerdem mit dem ersten Eingang eines zweiten Multiplizierers verbunden ist, dessen zweitem Eingang ebenfalls der Prädiktionsfaktor zugeführt ist, und daß der Ausgang des zweiten Multiplizierers den Ausgang der Recheneinheit bildet.

Die an sich bekannte Rechenschleife zur Ermittlung des Schätzwertes $\hat{s}_i$ wird hier zur Berechnung des benötigten Wertes $A^2 \cdot \hat{s}_{i-1}$ verwendet.

Es ist aus Aufwandsgründen vorteilhaft, daß als Quantisierer ein oder mehrere frei adressierbare Speicherbausteine vorgesehen sind.

Bei der Verwendung beispielsweise eines ROM's als Quantisierer sind die benötigten Ausgangssignale als Daten eingeschrieben. Das DPCM-Signal $\Delta s_i$ liegt als Adresse im Quantisierer an. Bei ausreichender Wortlänge

EP 0 104 470 B1

des ROM's (PROM, EPROM, RAM) können alle gewünschten Daten gleichzeitig aufgerufen werden. Beispielsweise beträgt die Wortbreite des quantisierten DPCM-Signals $\Delta s_{i,q}$ 4 Bits, während die anderen ausgegebenen Daten jeweils 6 Bits breit sind. In diesen Fall müßte die Wortbreite des ROM's 16 Bits betragen.

Es können selbstverständlich auch mehrere parallel angesteuerte Speicher verwendet werden.

Weitere vorteilhafte Ausbildungen sind in den übrigen Unteransprüchen angegeben.

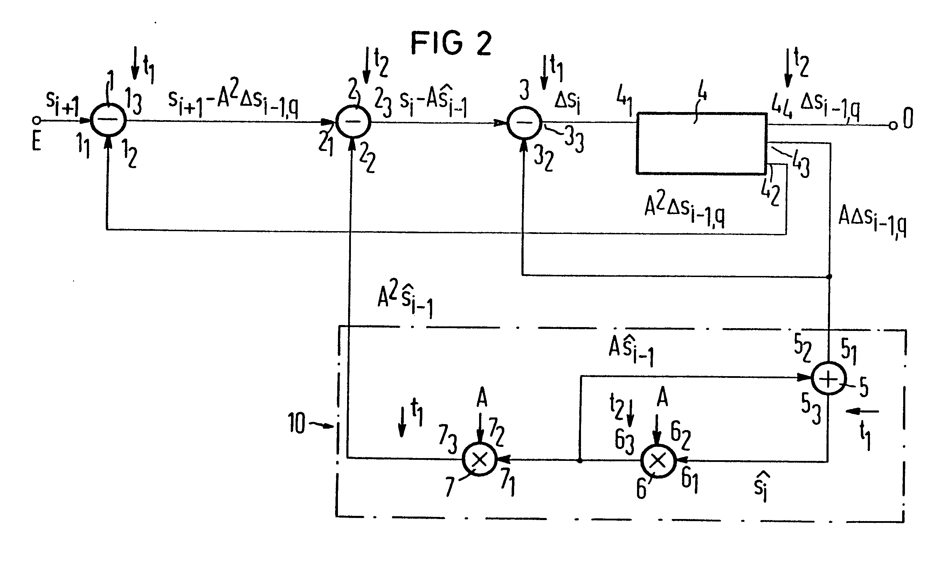

Ein Ausführungsbeispiel der Erfindung wird andhand der Fig. 1 und 2 näher erläutert.

Es zeigen:

Fig. 1    einen bekannten DPCM-Kodierer und
Fig. 2    einen erfindungsgemäßen DPCM-Kodierer.

Der in Fig. 1 dargestellte DPCM-Kodierer enthält einen Subtrahierer 1, dessen Eingang $1_1$ den Eingang E der Schaltungsanordnung darstellt. Der Ausgang $1_3$ des Subtrahierers 1 ist mit dem Eingang $8_1$ des Quantisierers 8 verbunden, dessen Ausgang $8_2$ den Ausgang 0 des DPCM-Kodierers darstellt, an dem das quantisierte DPCM-Signal $\Delta s_{i,q}$ abgegeben wird. Der Ausgang des Quantisierers 8 ist mit einem ersten Eingang $5_1$ eines Addierers 5 verbunden, dessen Ausgang $5_3$ mit dem ersten Eingang $6_1$ eines Multiplizierers 6 verbunden ist, dessen Ausgang $6_3$ mit dem zweiten Eingang $1_2$ des Subtrahierers und dem zweiten Eingang $5_2$ des Addierers 5 verbunden ist. Dem zweiten Eingang $6_2$ des Multiplizierers ist ein konstanter Prädiktionsfaktor $A \leq 1$ zugeführt. Dem Eingang der Schaltung werden PCM-Signalwerte $s_i$ zugeführt. Durch den Index "i" wird die zeitliche Reihenfolge der Signale gekennzeichnet.

Die Arbeitsweise des DPCM-Kodierers besteht darin, aus vorhergehenden Abtastwerten einen Schätzwert $\hat{s}_i$ zu errechnen. Aus der Differenz des anliegenden PCM-Signalwertes $s_i$ und dem Schätzwert $\hat{s}_i$ errechnet sich die Differenz $\Delta s_i$, die zunächst quantisiert und dann übertragen wird. Dieser quantisierte DPCM-Signalwert ist mit $\Delta s_{i,q}$ bezeichnet. Der zeitliche Ablauf der Berechnung eines DPCM-Signalwertes erfolgt in vier Schritten:

1)    bis zum Zeitpunkt $t_1$: Berechnung von $\Delta s_i = s_i - \hat{s}_i$,
2)    bis zum Zeitpunkt $t_2$: Quantis        on $\Delta s_i \rightarrow \Delta s_{i,q}$,
3)    bis zum Zeitpunkt $t_3$: Additio          $+ \Delta s_{i,q}$,
4)    bis zum Zeitpunkt $t_4$: Multiplikation. $A \cdot (\hat{s}_i + \Delta s_{i,q}) = \hat{s}_{i+1}$.

Diese vier Rechenschritte müssen innerhalb einer Zeit $t_A$ durchgeführt werden, die dem zeitlichen Abstand zweier aufeinanderfolgender PCM-Signalwerte $s_i$, $s_{i+1}$ entspricht.

Die Darstellung des PDCM-Kodierers ist rein schematisch. Hier wurde angenommen, daß zu den Zeitpunkten $t_1$ bis $t_4$ jeweils das Ausgangssignal der Schaltungselemente anliegt. Dies kann durch die Wahl geeigneter Bausteine erfolgen oder aber durch zusätzliche Laufzeitglieder oder geeignete Zwischenspeicher (bistabile Kippstufen) erreicht werden.

Der in Fig. 2 dargestellte DPCM-Kodierer enthält einen Quantisierer 4 mit drei Ausgängen $4_2$ bis $4_4$. Dem Eingang $4_1$ des Quantisierers 4 sind drei in Serie geschaltete Subtrahierer 1 bis 3 vorgeschaltet. Der Eingang $1_1$ des ersten Subtrahierers stellt den Eingang E der Schaltungsanordnung dar, an dem die zu verarbeitenden PCM-Signalwerte anliegen. Der erste Ausgang $4_2$ des Quantisierers 4 ist mit dem zweiten Eingang $1_2$ des ersten Subtrahierers verbunden. An den mit dem Index 2 bezeichneten Eingängen der Subtrahierer liegt jeweils der zu subtrahierende Signalwert an. Der zweite Ausgang $4_3$ des Quantisierers 4 ist mit dem Eingang $3_2$ des dritten Subtrahierers verbunden und über eine Recheneinheit 10 mit den Eingang $2_2$ des zweiten Subtrahierers. Die Recheneinheit 10 enthält einen Addierer 5, dessen erster Eingang $5_1$ mit dem zweiten Ausgang $4_3$ des Quantisierers verbunden ist. Der Ausgang $5_3$ des Addierers 5 ist mit dem ersten Eingang $6_1$ eines ersten Multiplizierers 6 verbunden. An dem zweiten Eingang $6_2$ des Multiplizierers 6 liegt der sogenannte Prädiktionsfaktor A an. Dieser Prädiktionsfaktor A ist kleiner gleich 1. Der Ausgang $6_3$ des ersten Multiplizierers ist mit dem zweiten Eingang $5_2$ des Addierers 5 und mit dem ersten Eingang $7_1$ eines zweiten Multiplizierers 7 verbunden, dem ebenfalls an seinem zweiten Eingang $7_2$ der Prädiktionsfaktor A zugeführt wird. Der Ausgang $7_3$ des zweiten Multiplizierers 7 stellt den Ausgang der Recheneinheit 10 dar und ist mit dem Subtraktionseingang $2_2$ des zweiten Subtrahierers 2 verbunden.

An dem dritten Ausgang $4_4$ des Quantisierers werden die quantisierten DPCM-Signale $\Delta s_{i,q}$ abgegeben. Der Index q dient hier zur Kennzeichnung dafür, daß ein Quantisierungsfehler bei jedem ausgegebenen Signal vorhanden ist.

Um die Schaltungsanordnung auf relativ einfache Weise erklären zu können, wird wieder angenommen, daß alle Rechenelemente und der Quantisierer getaktet sind, d. h. zu einem bestimmten Zeitpunkt an ihrem Ausgang das verarbeitete Signal abgeben, das bis zum nächsten Arbeitstakt erhalten bleibt. Das PCM-Signal am Eingang E wechselt entsprechend einem Arbeitstakt $t_1$. Ein zweiter Arbeitstakt $t_2$ weist die gleiche Periode auf, ist jedoch um 180° phasenverschoben. Die Subtrahierer 1 und 3 sowie der Addierer 5 und der Multiplizierer 7 arbeiten jeweils mit dem ersten Arbeitstakt $t_1$, während alle anderen Rechenelemente und der Quantisierer mit dem zweiten Arbeitstakt $t_2$ arbeiten. In dem Schaltbild sind die Signale für das Zeitintervall nach dem Arbeitstakt $t_1$ dargestellt. Nach den nächsten Arbeitstakt $t_2$ liegt das quantisierte DPCM-Signal $\Delta s_i$ am Ausgang 0 des Quantisierers an.

Jeder Schätzwert $\hat{s}_i$ wird aus den vorhergehenden Werten berechnet. So berechnet sich der Schätzwert $\hat{s}_{i+1}$ aus

3

$$\hat{s}_{i+1} = A (\hat{s}_i + \Delta s_{i,q}) = A \cdot \hat{s}_i + A \cdot \Delta s_{i,q}$$

Entsprechend erfolgt die Berechnung der Schätzwerte $\hat{s}_{i-1}$ bis $\hat{s}_{i+n}$ aus den zeitlich vorhergehenden Schätzwerten und quantisierten DPCM-Signalen:

GL 2.0
$$\hat{s}_{i-1} = A(\hat{s}_{i-2} + \Delta s_{i-2,q})$$

GL 2.1
$$\hat{s}_i = A(\hat{s}_{i-1} + \Delta s_{i-1,q}) = A(A(\hat{s}_{i-2} + \Delta s_{i-2,q}) + \Delta s_{i-1,q})$$

GL 2.2
$$\hat{s}_{i+1} = A(\hat{s}_i + \Delta s_{i,q}) = A(A(\hat{s}_{i-1} + \Delta s_{i-1,q}) + \Delta s_{i,q})$$

.

GL 2.3
$$\hat{s}_{i+n} = A(\hat{s}_{i+n-1} + \Delta s_{i+n-1,q}) = A(A(\hat{s}_{i+n-2} + \Delta s_{i+n-2,q}) + \Delta s_{i+n-1,q})$$

Die Berechnung des Schätzwertes $\hat{s}_{i+1}$ erfordert die zeitlich unmittelbar vorher erzeugte Differenz $\Delta s_{i,q}$ sowie die bereits ein Zeitintervall $t_a$ (dies entspricht der Periode zweier aufeinanderfolgender PCM-Signalwerte $s_i$, $s_{i+1}$ am Eingang E des DPCM-Kodierers) vorher zur Verfügung stehende Werte $\hat{s}_{i-1}$ und $\Delta s_{i-1,q}$ (GL 2.2). Die in Fig. 2 dargestellte Schaltung ist deshalb so konzipiert, daß der Signalwert $s_{i+1}$ bereits mit $\Delta s_{i-1,q}$ und $\hat{s}_{i-1}$ verknüpft wird, bevor der PDCM-Signalwert $\Delta s_i$ in einer dritten Schleife errechnet wird.

Um die Funktion der Schaltung genauer erklären zu können, soll der PCM-Signalwert $s_i$ vom Eingang E bis zum Ausgang 0 des DPCM-Kodierers verfolgt werden. Vor einem Zeitpunkt $t_{1,1}$ liegt der PCM-Signalwert $s_i$ am Eingang E des ersten Subtrahierers 1 an. Am Subtraktionseingang $1_2$ des ersten Subtrahierers liegt der vom Quantisierer 4 abgegebene Wert $A^2 \cdot \Delta s_{i-2,q}$ an. Nach dem nächsten Takt $t_{1,1}$ wird am Ausgang $1_3$ des ersten Subtrahierers der Zwischenwert:

GL 3.1 $Z_{i,1} = s_i - A^2 \Delta s_{i-2,q}$

abgegeben.

An den Eingängen des zweiten Subtrahierers 2 liegt nunmehr der eben errechnete Zwischenwert $Z_{i,1}$ an und am zweiten Eingang liegt als Zwischenwert $A^2 \cdot \hat{s}_{i-2}$ an, wobei A der Prädiktionsfaktor $< 1$ ist. Nach dem nächsten Takt $t_{2,1}$ liegt am Ausgang des zweiten Subtrahierers somit ein zweiter Zwischenwert $Z_{i,2}$ an:

GL 3.2 $Z_{i,2} = s_i - A^2 \Delta s_{i-2,q} - A^2 \hat{s}_{i-2}.$

Mit Gleichung GL 2.0 ergibt sich:

GL 3.21 $Z_{i,2} = s_i - A \hat{s}_{i-1}$

Nach dem Arbeitstakt $t_{2,1}$ liegt bereits am zweiten Ausgang $4_3$ des Quantisierers 4 der angegebene Rechenwert $A \cdot \Delta s_{i-1,q}$. Nach dem nächsten Arbeitstakt $t_{1,2}$ liegt somit am Ausgang des dritten Subtrahierers 3 der dritte Zwischenwert $Z_{i,3}$ an:

GL 3.3 $Z_{i,3} = s_1 - A \hat{s}_{i-1} - A \cdot \Delta s_{i-1,q}$

Mit Gleichung GL 2.1 ergibt sich für $Z_{i,3}$:

GL 3.31 $Z_{i,3} = s_i - \hat{s}_i = \Delta s_i$

Der dritte Zwischenwert $Z_{i,3}$ entspricht somit dem DPCM-Signalwert $\Delta s_i$. Für diesen Zeitpunkt, wie bereits erwähnt, sind alle Rechen- und Zwischenwerte in Fig. 2 angegeben. Nach dem nächsten Arbeitstakt $t_{2,2}$ liegt das quantisierte DPCM-Signal $\Delta s_{i,q}$ am Ausgang 0 des DPCM-Kodierers an. Die in Fig. 2 eingetragenen Signalwerte beziehen sich auf den Zeitpunkt $t_{1,2}$.

Der Schaltungsanordnung kann sowohl mit getakteten als auch ungetakteten Rechenelementen aufgebaut werden. Bei der Verwendung von ungetakteten Rechenelementen sind selbstverständlich die Laufzeiten zu berücksichtigen und eventuell durch Einschalten von Laufzeitgliedern, z. B. bei der Berechnung des Schätzwertes $\hat{s}_i$ in der Recheneinheit 10 zu berücksichtigen. Die gemischte Verwendung von getakteten und ungetakteten Rechenelementen kann ebenfalls günstige Ausführungen ergeben.

Die Realisation eines DPCM-Dekodierers kann selbstverständlich nach dem gleichen Prinzip erfolgen.

**Patentansprüche**

1. Schneller DPCM-Kodierer mit einem Quantisierer (4) und mit mehreren Rechenschleifen zur Ermittlung eines DPCM-Signalwertes ($\Delta s_i$), bei dem von einem Abtastwert ($s_{i+1}$) mehrere Zwischenwerte ($A^2\Delta s_{i-1,q}$, $A^2\hat{s}_{i-1}$, $A\Delta s_{i-1,q}$), von denen mindestens einer in einer Recheneinheit (10) ermittelt wird, in Subtrahierern (1, 2, 3) subtrahiert werden, die dem Quantisierer (4) in Reihe vorgeschaltet sind, dadurch gekennzeichnet, daß der Quantisierer (4) einen ersten Ausgang ($4_2$) aufweist, an dem ein mit dem Quadrat eines Prädiktionsfaktors (A) multiplizierter quantisierter DPCM-Signalwert ($A^2\Delta s_{i,q}$) abgegeben wird, und einen zweiten Ausgang ($4_3$) aufweist, an dem ein mit dem Prädiktionsfaktor (A) multiplizierter DPCM-Signalwert ($A\Delta s_{i,q}$) abgegeben wird, daß der erste Ausgang ($4_2$) mit dem Subtraktionseingang ($1_2$) eines ersten vorgeschalteten Subtrahierers (1) verbunden ist, daß der zweite Ausgang ($4_3$) über die Recheneinheit (10) mit dem Subtraktionseingang ($2_2$) eines zweiten Subtrahierers (2) und direkt mit dem Subtraktionseingang ($3_2$) eines dritten, dem Quantisierer (4) unmittelbar vorgeschalteten Subtrahierers (3) verbunden ist.

2. DPCM-Kodierer nach Anspruch 1, dadurch gekennzeichnet, daß ein dritter Ausgang ($4_4$) des Quantisierers (4) vorgesehen ist, an dem die quantisierten DPCM-Signalwerte ($\Delta s_{i,q}$) abgegeben werden.

3. DPCM-Kodierer nach Anspruch 1, dadurch gekennzeichnet, daß ein zusätzlicher Multiplizierer vorgesehen ist, der an den ersten oder zweiten Ausgang ($4_2$ oder $4_3$) des Quantisierers angeschaltet ist und durch Multiplikation mit $\frac{1}{A^2}$ oder $\frac{1}{A}$ jeweils den quantisierten DPCM-Signalwert $\Delta s_{i,q}$ errechnet.

4. DPCM-Kodierer nach einem der vorhergehenden Ansprüche, dadurch gekennzeichnet, daß die Recheneinheit (10) einen Addierer (5) enthält, dessen erster Eingang ($5_1$) an den zweiten Ausgang ($4_3$) des Quantisierers (4) angeschlossen ist, daß der Ausgang ($5_3$) des Addierers (5) mit dem ersten Eingang ($6_1$) eines ersten Multiplizierers (6) verbunden ist, dessen zweitem Eingang ($6_2$) der Prädiktionsfaktor (A) zugeführt ist und dessen Ausgang ($6_3$) an den zweiten Eingang ($5_2$) des Addierers (5) geführt ist und außerdem mit dem ersten Eingang ($7_1$) eines zweiten Multiplizierers (7) verbunden ist, dessen zweiten Eingang ($7_2$) ebenfalls der Prädiktionsfaktor zugeführt ist, und daß der Ausgang ($7_3$) des zweiten Multiplizierers (7) den Ausgang der Recheneinheit (10) bildet.

5. DPCM-Kodierer nach einem der vorhergehenden Ansprüche, dadurch gekennzeichnet, daß getaktete Rechenelemente (Addierer, Multiplizierer, Subtrahierer, Quantisierer) vorgesehen sind.

6. DPCM-Kodierer nach einem der vorhergehenden Ansprüche, dadurch gekennzeichnet, daß Laufzeitglieder zwischen den Rechenelementen eingefügt sind.

7. DPCM-Kodierer nach einem der vorhergehenden Ansprüche, dadurch gekennzeichnet, daß als Quantisierer (4) ein oder mehrere frei adressierbare Speicherbausteine vorgesehen sind.

8. DPCM-Kodierer nach einem der vorhergehenden Ansprüche, dadurch gekennzeichnet, daß statt der Subtrahierer (1 bis 3) Addierer vorgesehen sind, denen das zu subtrahierende Signal als Komplement zugeführt ist.

9. DPCM-Kodierer nach einem der vorhergehenden Ansprüche, dadurch gekennzeichnet, daß er als integrierte Schaltung realisiert ist.

**Claims**

1. Fast DPCM encoder having a quantizing circuit (4) and having several computing loops for determining a DPCM signal value ($\Delta s_i$), in which several intermediate values ($A^2\Delta s_{i-1,q}$, $A^2\hat{s}_{i-1}$, $A\Delta s_{i-1,q}$), of which at least one is determined in a computing unit (10), are subtracted from a sample ($s_{i+1}$) in subtracting circuits (1, 2, 3) which are connected in series preceding the quantizing circuit (4), characterized in that the quantizing circuit (4) exhibits a first output ($4_2$), at which a quantized DPCM signal value ($A^2\Delta s_{i,q}$), which is multiplied by the square of a prediction factor (A), is emitted, and exhibits a second output ($4_3$), at which a DPCM signal value ($A\Delta s_{i,q}$), multiplied by the prediction factor (A), is emitted, that the first output ($4_2$) is connected to the subtraction input ($1_2$) of a first preceding subtracting circuit (1), that the second output ($4_3$) is connected via the computing unit (10) to the subtraction input ($2_2$) of a second subtracting circuit (2) and directly to the subtraction input ($3_2$) of a third subtracting circuit (3) which directly precedes the quantizing circuit (4).

2. DPCM encoder according to Claim 1, characterized in that a third output ($4_4$) of the quantizing circuit (4) is provided, at which the quantized DPCM signal values ($\Delta s_{i,q}$) are emitted.

3. DPCM encoder according to Claim 1, characterized in that an additional multiplier is provided, which is connected to the first or second output ($4_2$ or $4_3$) of the quantizing circuit and in each case calcuates the quantized DPCM signal value $\Delta s_{i,q}$ by multiplication by $\frac{1}{A^2}$ or $\frac{1}{A}$.

4. DPCM encoder according to one of the preceding claims, characterized in that the computing unit (10) contains an adding circuit (5), the first input ($5_1$) of which is connected to the second output ($4_3$) of the quantizing circuit (4), that the output ($5_3$) of the adding circuit (5) is connected to the first input ($6_1$) of a first multiplier (6), the second input ($6_2$) of which is supplied with the prediction factor (A) and the output ($6_3$) of which is connected to the second input ($5_2$) of the adding circuit (5) and is additionally connected to the first input ($7_1$) of a second multiplier (7), the second input ($7_2$) of which is also supplied with the prediction factor, and that the output ($7_3$) of the second multiplier (7) forms the output of the computing unit (10).

5. DPCM encoder according to one of the preceding claims, characterized in that clocked computing elements (adding circuit, multipliers, subtracting circuits, quantizing circuits) are provided.

6. DPCM encoder according to one of the preceding claims, characterized in that delay sections are inserted between the computing elements.

7. DPCM encoder according to one of the preceding claims, characterized in that one or more freely addressable memory chips are provided as quantizing circuit (4).

8. DPCM encoder according to one of the preceding claims, characterized in that, instead of the subtracting circuits (1 to 3), adding circuits are provided which are supplied with the signal to be subtracted as a complement.

9. DPCM encoder according to one of the preceding claims, characterized in that it is implemented as an integrated circuit.

## Revendications

1. Codeur DPCM rapide, comprenant un dispositif de quantification (4) et plusieurs boucles de calcul pour déterminer une valeur de signal DPCM ($\Delta s_i$), dans lequel plusieurs valeurs intermédiaires ($A^2\Delta s_{i-1,q}$, $A^2\hat{s}_{i-1}$, $A\Delta s_{i-1,q}$) dont une au moins est déterminée dans une unité de calcul (10), sont soustraites d'une valeur d'échantillonnage ($s_{i+1}$) dans des soustracteurs (1, 2, 3) montés en série avec le dispositif de quantification (4) en amont de lui,
<u>caractérisé en ce</u>
que le dispositif de quantification (4) présente une première sortie ($4_2$) sur laquelle est délivrée une valeur de signal DPCM quantifiés ($A^2\Delta s_{i,q}$) multipliée par le carré d'un facteur d'extrapolation (A), et une deuxième sortie ($4_3$) sur laquelle est délivrée une valeur de signal DPCM ($A\Delta s_{i,q}$) multipliée par le facteur d'extrapolation (A),
que la première sortie ($4_2$) est reliée à l'entrée de soustraction ($1_2$) d'un premier soustracteur (1) prévu en amont, et
que la deuxième sortie ($4_3$) est reliée à travers l'unité de calcul (10) à l'entrée de soustraction ($2_2$) d'un deuxième soustracteur (2) et est reliée directement à l'entrée de soustraction ($3_2$) d'un troisième soustracteur (3) précédant directement le dispositif de quantification (4).

2. Codeur selon la revendication 1, caractérisé en ce que le dispositif de quantification (4) possède une troisième sortie ($4_4$) sur laquelle sont délivrées les valeurs de signal DPCM quantifiées ($\Delta s_{i,q}$).

3. Codeur selon la revendication 1, caractérisé en ce qu'il comprend un multiplexeur supplémentaire connecté à la première ou la deuxième sortie ($4_2$ ou $4_3$) du dispositif de quantification et qui calcule chaque fois la valeur de signal DPCM quantifiée ($\Delta s_{i,q}$).

4. Codeur selon une des revendications précédentes, caractérisé en ce que l'unité de calcul (10) contient un additionneur (5) dont la première entrée ($5_1$) est raccordée à la deuxième sortie ($4_3$) du dispositif de quantification (4), que la sortie ($5_3$) de l'additionneur (5) est reliée à la première entrée ($6_1$) du premier multiplicateur (6) dont la seconde entrée ($6_2$) reçoit le facteur d'extrapolation (A) et dont la sortie ($6_3$) est connectée à la seconde entrée ($5_2$) de l'additionneur (5), de même qu'à la première entrée ($7_1$) d'un second multiplexeur (7) dont la deuxième entrée ($7_2$) reçoit également le facteur d'extrapolation, et que la sortie ($7_3$) du second multiplexeur (7) forme la sortie de l'unité de calcul (10).

5. Codeur selon une des revendications précédentes, caractérisé en ce qu'il comprend des éléments de calcul (additionneur, multiplicateurs, soustracteurs, dispositif de quantification) cadencés.

6. Codeur selon une des revendications précédentes, caractérisé en ce que des organes de retard sont intercalés entre les éléments de calcul.

7. Codeur selon une des revendications précédentes, caractérisé en ce que le dispositif de quantification (4) est constitué par un ou plusieurs composants de mémoire adressable(s) librement.

8. Codeur selon une des revendications précédentes, caractérisé en ce qu'il comprend, à la place des soustracteurs (1 à 3) des additionneurs auxquels le signal à soustraire est appliqué sous forme de complément.

9. Codeur selon une des revendications précédentes, caractérisé en ce qu'il est réalisé comme un circuit intégré.

# FIG 1

FIG 2